# EUROPEAN PATENT APPLICATION

(11) **EP 4 614 570 A1**
(43) Date of publication of application: **10.09.2025**
(21) Application number: 24807618.4
(22) Date of filing: 16.02.2024
(51) Int. Cl.: H01L 25/075, H01L 33/62, H01L 33/56, H01L 33/60, H01L 33/48, H01L 33/38

(54) **DISPLAY APPARATUS HAVING DISPLAY MODULE, AND MANUFACTURING METHOD THEREOF**

(30) Priority: 12.05.2023 KR 20230061747
(71) Applicant: Samsung Electronics Co., Ltd., Suwon-si, Gyeonggi-do 16677 (KR)
(72) Inventor: JUNG, Jonghoon, Suwon-si Gyeonggi-do 16677 (KR); KIM, Jinyoung, Suwon-si Gyeonggi-do 16677 (KR); MIN, Sungyong, Suwon-si Gyeonggi-do 16677 (KR); LEE, Changjoon, Suwon-si Gyeonggi-do 16677 (KR)
(74) Representative: Gulde & Partner
(86) International application number: PCT/KR2024/095333
(87) International publication number: WO 2024/237748

(57) **Abstract**

A display module includes: a substrate including a mounting surface and a pad electrode on the mounting surface; an inorganic light emitting element including a contact electrode corresponding to the pad electrode; a bump disposed between the pad electrode and the contact electrode to bond the pad electrode and the contact electrode, the bump being electrically connecting the pad electrode to the contact electrode; a reflective member configured to underfill the inorganic light emitting element to cover side surfaces of the inorganic light emitting element and a bottom surface of the inorganic light emitting element, and configured to reflect light; and a cover member configured to cover side surfaces of the reflective member and the mounting surface of the substrate, the cover member having a black color.

## Description

### [TECHNICAL FIELD]

The disclosure relates to a display module including an inorganic light emitting element and a method of manufacturing the same.

### [BACKGROUND ART]

In general, a display apparatus is configured to visually display data information, such as characters, shapes, or the like, and images, or the like.

A micro light emitting diode ("micro LED") display panel includes a plurality of inorganic light emitting diodes ("inorganic LEDs"). Each of the plurality of the inorganic LEDs is 100 µm or less. A micro LED panel is a self-luminous panel, and thus, does not require a backlight. In addition, the micro LED panel is resistant to burn-in and has features of high brightness, resolution, power consumption, and durability.

Because inorganic LEDs included in a micro LED panel is very small, the electrical connection between electrodes of the inorganic light-emitting elements and electrodes of a substrate may be unstable. In addition, bonding between the inorganic light emitting elements and the substrate may also be unstable.

### [DISCLOSURE]

### [TECHNICAL PROBLEM]

Provided are a display module in which an electrical connection between an electrode of an inorganic light emitting element and an electrode of a substrate is stabilized, and a method of manufacturing the same.

Provided are a display module having enhanced bonding between an inorganic light-emitting element and a substrate, and a method of manufacturing the same.

Provided are a display module including an inorganic light-emitting element with improved light efficiency, and a method of manufacturing the same.

Provided are a display module having reduced material costs and a method of manufacturing the same.

Technical tasks to be achieved in this disclosure are not limited to the technical tasks mentioned above, and other technical tasks not mentioned will be clearly understood by those skilled in the art from the description below.

### [TECHNICAL SOLUTION]

According to an aspect of the disclosure, a display module includes: a substrate including a mounting surface and a pad electrode on the mounting surface; an inorganic light emitting element including a contact electrode corresponding to the pad electrode; a bump disposed between the pad electrode and the contact electrode to bond the pad electrode and the contact electrode, the bump being electrically connecting the pad electrode to the contact electrode; a reflective member configured to underfill the inorganic light emitting element to cover side surfaces of the inorganic light emitting element and a bottom surface of the inorganic light emitting element, and configured to reflect light; and a cover member configured to cover side surfaces of the reflective member and the mounting surface of the substrate, the cover member having a black color.

According to an aspect of the disclosure, a display module includes: a substrate including a mounting surface and a pad electrode; an inorganic light emitting element including a contact electrode and the pad electrode; a bump between the pad electrode and the contact electrode, the bump bonding the pad electrode and the contact electrode by electrically connecting the pad electrode to the contact electrode; a reflective member configured to cover side surfaces of the inorganic light emitting element and a bottom surface of the inorganic light emitting element; and a cover member configured to cover side surfaces of the reflective member and the mounting surface of the substrate, wherein the reflective module is formed by dispensing a resin onto the substrate, wherein the resin is configured to have a color in the grey range, and wherein the reflective member includes a plurality of reflective beads distributed within the resin.

### [DESCRIPTION OF DRAWINGS]

FIG. 1 is a view illustrating a display apparatus according to an embodiment of the disclosure;
FIG. 2 is an exploded view illustrating main components of the display apparatus shown in FIG. 1;
FIG. 3 is an enlarged cross-sectional view of a partial configuration of a display module shown in FIG. 1;
FIG. 4 is an enlarged cross-sectional view of an inorganic light-emitting element shown in FIG. 3;
FIG. 5 is a cross-sectional view illustrating the inorganic light-emitting element of the display module according to an embodiment of the disclosure;
FIG. 6 is a cross-sectional view illustrating the inorganic light-emitting element of the display module according to an embodiment of the disclosure;
FIG. 7 is a flowchart for explaining a method of manufacturing the display module according to an embodiment of the disclosure;
FIG. 8 is a cross-sectional view illustrating a substrate of the display module according to an embodiment of the disclosure;
FIG. 9 is a cross-sectional view of the inorganic light-emitting element transferred onto the substrate of the display module according to an embodiment of the disclosure;
FIG. 10 is a schematic cross-sectional view illustrating the inorganic light-emitting element transferred onto the substrate of the display module according to an embodiment of the disclosure, which is placed in a reflow process;
FIG. 11 is a schematic cross-sectional view of dispensing a reflective member onto the substrate of the display module according to an embodiment of the disclosure;
FIG. 12 is a schematic cross-sectional view of ultraviolet (UV) curing of the reflective member dispensed onto the substrate of the display module according to an embodiment of the disclosure;
FIG. 13 is a schematic cross-sectional view of dispensing a cover member onto the substrate of the display module according to an embodiment of the disclosure;
FIG. 14 is a schematic cross-sectional view of UV curing of the cover member dispensed onto the substrate of the display module according to an embodiment of the disclosure; and
FIG. 15 is a schematic cross-sectional view of heat curing of the cover member of the display module according to an embodiment of the disclosure.

### [MODES OF THE INVENTION]

One or more embodiments of the disclosure and terms used therein are not intended to limit the technical features described in this disclosure to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In this disclosure, phrases, such as "A or B", "at least one of A and B", "at least one of A or B," "A, B or C," "at least one of A, B and C," and "at least one of A, B, or C", may include any one or all possible combinations of items listed together in the corresponding phrase among the phrases.

As used herein, the term "and/or" includes any and all combinations of one or more of associated listed items.

Terms such as "1^{st}", "2^{nd}", or "first", "second", or "primary", "secondary" may be used simply to distinguish a component from other components, without limiting the component in other aspects (e.g., importance or order).

When an element (e.g., a first element) is referred to as being "(functionally or communicatively) coupled" or "connected" to another element (e.g., a second element), the first element may be connected to the second element, directly (e.g., wired), wirelessly, or through a third element.

When the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

When a certain component is referred to as being "connected to", "coupled to", "supported by" or "in contact with" another component, it can be directly or indirectly connected to, coupled to, supported by, or in contact with the other component. When a component is indirectly connected to, coupled to, supported by, or in contact with another component, it may be connected to, coupled to, supported by, or in contact with the other component through a third component.

When a component is referred to as being "on" or "over" another component, it can be directly on the other component or intervening components may also be present.

Further, as used in the disclosure, the terms "front", "rear", "top", "bottom", "side", "left", "right", "upper", "lower", and the like are defined with reference to the drawings, and are not intended to limit the shape and position of each component.

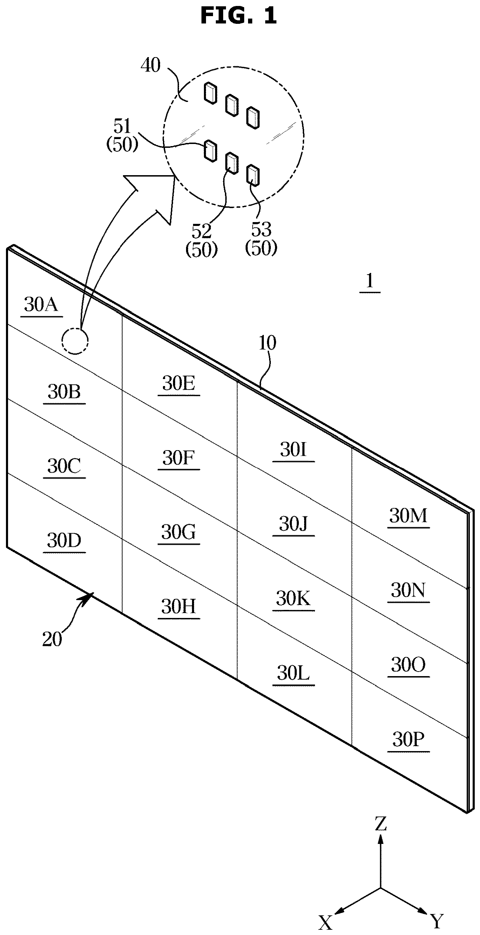

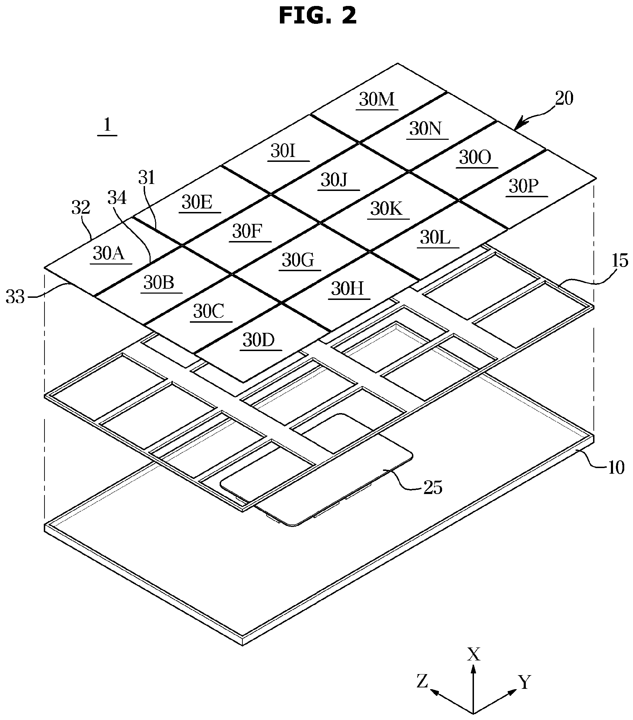

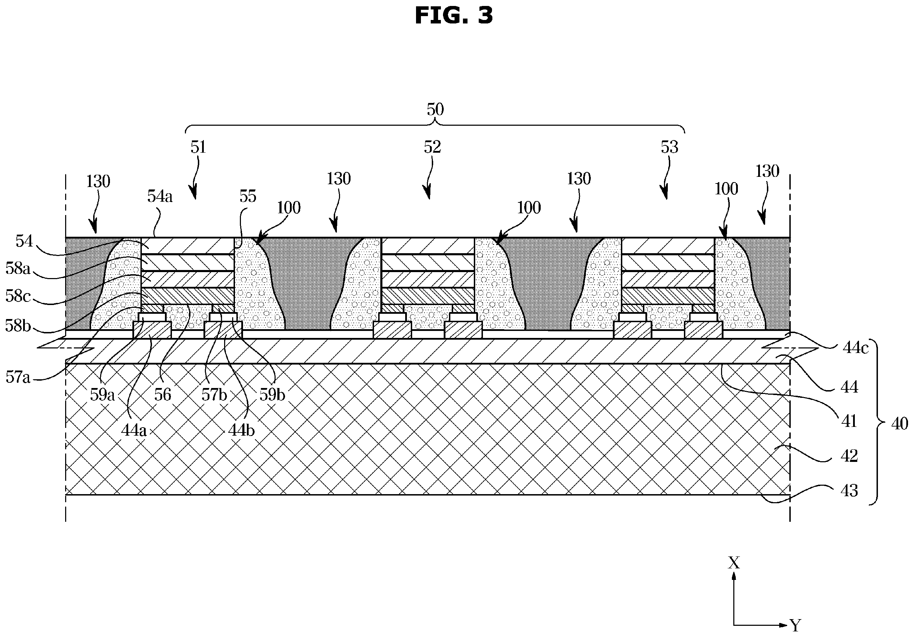

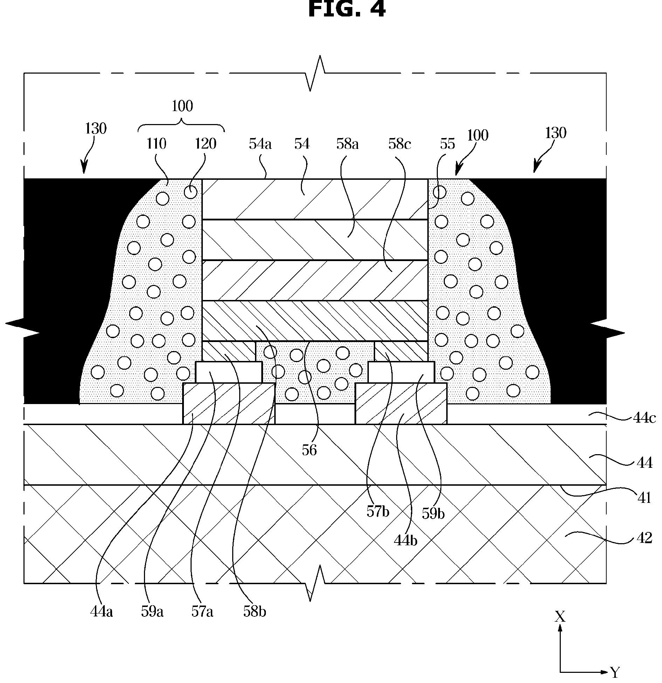

FIG. 1 is a view illustrating a display apparatus according to an embodiment of the disclosure. FIG. 2 is an exploded view illustrating main components of the display apparatus shown in FIG. 1. FIG. 3 is an enlarged cross-sectional view of a partial configuration of the display module shown in FIG. 1. FIG. 4 is an enlarged cross-sectional view of an inorganic light emitting element shown in FIG. 3.

In the accompanying drawings, some components of a display apparatus 1, including a plurality of inorganic light emitting elements 50, are micro-scale configurations having a size of several µm to hundreds of µm, and for ease of description, the scale of some components (e.g., the plurality of inorganic light emitting elements) is shown to be exaggerated.

The display apparatus 1 may display information, materials, data, or the like in the form of characters, geometric shapes, graphics, images, and the like, and the display apparatus 1 may be complemented as a television (TV), personal computer (PC), mobile, digital signage, and the like.

According to an embodiment, as shown in FIGS. 1 and 2, the display apparatus 1 may include a display panel 20 that displays an image, a power supply device that supplies power to the display panel 20, a main board 25 that controls an overall operation of the display panel 20, a frame 15 that supports the display panel 20, and a rear cover 10 that covers a rear side of the frame 15.

The display panel 20 may include a plurality of display modules 30A-30P, a drive board that is configured to drive each display module 30A-30P, and a timing controller board (TCON) that is configured to generate timing signals necessary to control the respective display modules 30A-30P.

The rear cover 10 may support the display panel 20. The rear cover 10 may be placed on a floor by means of a stand, or may be mounted on a wall by means of a hanger.

The plurality of display modules 30A-30P may be arranged up, down, left and right so as to be adjacent to each other. The plurality of display modules 30A-30P may be arranged in an M * N matrix form. In an embodiment, 16 display modules 30A-30P may be provided and arranged in a 4 * 4 matrix, but there is no limit to the number and arrangement of the plurality of display modules 30A-30P.

The plurality of display modules 30A-30P may be mounted on the frame 15. The plurality of display modules 30A-30P may be installed on the frame 15 by means of various conventional methods, such as a magnetic force using a magnet or a mechanical fitting structure. The rear cover 10 may be coupled to a rear side of the frame 15, and the rear cover 10 may form a rear exterior of the display apparatus 1.

The rear cover 10 may include a metallic material. Accordingly, heat generated from the plurality of display modules 30A-30P and the frame 15 may be easily conducted to the rear cover 10, thereby increasing the heat dissipation efficiency of the display apparatus 1.

As described above, according to an embodiment, the display apparatus 1 may implement a large screen by tiling the plurality of display modules 30A-30P.

In an embodiment, each of the individual display modules in the plurality of display modules 30A-30P may be applied to a display apparatus. As a single unit, the display modules 30A-30P may be installed and applied to a wearable device, a portable device, a handheld device, and various electronic products or equipment requiring a display. In addition, as in the above embodiment, the display modules 30A-30P may be applied to a display apparatus, such as a monitor for a PC, a high-resolution TV, signage, an electronic display, and the like through a plurality of assembly arrangements in a matrix type.

The plurality of display modules 30A-30P may have the same configuration as each other. Accordingly, the description of any one display module described below may be equally applicable to all other display modules.

Since all of the plurality of display modules 30A-30P may be formed identically, each of the plurality of display modules 30A-30P will be described below based on a first display module 30A.

To avoid duplicate descriptions, a configuration of the plurality of display modules 30A-30P will be described as represented by a display module 30 and a substrate 40.

As an example, the first display module 30A of the plurality of display modules 30A-30P may be formed in a quadrangle type. The first display module 30A may be arranged in a rectangular shape or a square type. Accordingly, the first display module 30A may include edges 31, 32, 33, and 34 formed in the up, down, left, and right directions based on a first direction X, which is a forward direction.

Referring to FIG. 3, each of the plurality of display modules 30A-30P may include the substrate 40 and a plurality of inorganic light emitting elements 50 mounted on the substrate 40. The plurality of inorganic light emitting elements 50 may be mounted on a mounting surface 41 of the substrate 40 facing in the first direction X.

The substrate 40 may be formed in a quadrangle type. In an embodiment, each of the plurality of display modules 30A-30P may be provided in a rectangular shape, and the substrate 40 may be formed in a rectangular shape to correspond thereto. The substrate 40 may be provided in a rectangular type or a square type.

The substrate 40 may include a substrate body 42, the mounting surface 41 (one side of the substrate body 42), and a rear surface 43 (the other side of the substrate body 42), which is disposed on the opposite side to the mounting surface 41.

In an embodiment, the substrate 40 may include a thin film transistor (TFT) layer 44 formed on the substrate body 42 to drive the plurality of inorganic light emitting elements 50. The substrate body 42 may include a glass substrate. The substrate 40 may include a chip on glass (COG) type substrate. The substrate 40 may include a first pad electrode 44a and a second pad electrode 44b that are provided to electrically or operatively connect the inorganic light emitting elements 50 to the TFT layer 44.

The TFT of the TFT layer 44 may not be limited to a specific structure or type, and may be configured in various types. The TFT of the TFT layer 44 according to an embodiment may be implemented as a low temperature poly silicon (LTPS) TFT, an oxide TFT, a poly-silicon (or a-silicon) TFT, as an organic TFT, and a graphene TFT.

In addition, the TFT layer 44 may be replaced with a complementary metal oxide semiconductor (CMOS) type, or an n-type MOSFET, or a p-type MOSFET transistor when the substrate body 42 of the substrate 40 is provided with a silicon wafer.

The substrate 40 may further include a light absorbing layer 44c to improve contrast by absorbing ambient light. The light absorbing layer 44c may be formed on the entire mounting surface 41 of the substrate 40. The light absorbing layer 44c may be formed between the TFT layer 44 and a non-conductive film 100.

The plurality of inorganic light emitting elements 50 may include an inorganic material and may include inorganic light emitting elements each having dimensions of several µm to several tens of µm in width, length, and height, respectively. The inorganic light emitting element may have a length of 100 µm or less on a short side of the width, length, and height. The inorganic light emitting elements 50 may be picked up from a sapphire or silicon wafer and directly transferred onto the substrate 40. The plurality of inorganic light emitting elements 50 may be picked up and transferred by an electrostatic method using an electrostatic head, or by a stamp method using an elastic polymer material, such as polydimethylsiloxane (PDMS) or silicon as the head.

Each of the plurality of inorganic light emitting elements 50 may be a light emitting structure including an n-type semiconductor 58a, an active layer 58c, a p-type semiconductor 58b, a first contact electrode 57a, and a second contact electrode 57b. Hereinafter, such structure will be described by using one of the plurality of inorganic light emitting elements 50 as an example.

In an embodiment, one of the first contact electrode 57a and the second contact electrode 57b may be electrically connected to the n-type semiconductor 58a, and the other may be electrically connected to the p-type semiconductor 58b.

In FIG. 3, the first contact electrode 57a and the second contact electrode 57b may be in a form of a flip chip, arranged horizontally and facing the same direction (opposite to a direction of light emission).

The inorganic light emitting element 50 may include a protective layer 54. According to an embodiment, the protective layer 54 may be disposed on top of the n-type semiconductor 58a. The protective layer 54 may be disposed on the outermost side of the inorganic light emitting element 50 in the first direction X.

As shown in FIG. 3, when mounted on the mounting surface 41, the inorganic light emitting element 50 may have a light emitting surface 54a disposed toward the first direction X, a side surface 55, and a bottom surface 56 disposed on the opposite side of the light emitting surface 54a. The first contact electrode 57a and the second contact electrode 57b may be formed on the bottom surface 56 of the inorganic light emitting element 50. The contact electrodes 57a and 57b of the inorganic light emitting element 50 may be disposed on the opposite side of the light emitting surface 54a, which is the opposite side of a direction to which light is emitted.

According to an embodiment, the inorganic light emitting element 50 may include a first bump 59a formed on the first contact electrode 57a and a second bump 59a formed on the second contact electrode 57b.

As shown in FIG. 3, the first bump 59a may be plated on the first contact electrode 57a to cover the first contact electrode 57a. The second bump 59b may be plated on the second contact electrode 57b to cover the second contact electrode 57b. The first bump 59a and the second bump 59b may be melted by application of heat and pressure. When being molten, the first bump 59a may electrically connect the first contact electrode 57a and the first pad electrode 44a. When being molten, the second bump 59b may electrically connect the second contact electrode 57b and the second pad electrode 44b.

The first contact electrode 57a may be disposed facing the mounting surface 41 and may be electrically connected to the TFT layer 44. The first contact electrode 57a may be electrically connected to the first pad electrode 44a via the first bump 59a. The first contact electrode 57a may be electrically connected to the TFT layer 44 via the first pad electrode 44a.

The second contact electrode 57b may face the mounting surface 41 and may be electrically connected to the TFT layer 44. The second contact electrode 57b may be electrically connected to the second pad electrode 44b via the second bump 59b. The second contact electrode 57b may be electrically connected to the TFT layer 44 via the second pad electrode 44b.

Alternatively, the first bump 59a may be arranged to cover at least a portion of the first pad electrode 44a. The second bump 59b may be arranged to cover at least a portion of the second pad electrode 44b. The first bump 59a may be provided between the first contact electrode 57a and the first pad electrode 44a to electrically connect the first contact electrode 57a and the first pad electrode 44a. The second bump 59b may be provided between the second contact electrode 57b and the second pad electrode 44b to electrically connect the second contact electrode 57b and the second pad electrode 44b.

The light emitting surface 54a emits light in a direction opposite to the direction in which the contact electrodes 57a and 57b are disposed. The light emitting surface 54a may refer to an upper surface of the protective layer 54.

By such arrangement, when light generated by the active layer 58c is irradiated in the first direction X through the light emitting surface 54a, the light may be irradiated in the first direction X without interference from the first contact electrode 57a or the second contact electrode 57b.

The plurality of inorganic light emitting elements 50 may include a red light emitting element 51, a green light emitting element 52, and a blue light emitting element 53. The light emitting element 50 may be mounted on the mounting surface 41 of the substrate 40 as a unit with a series of the red light emitting element 51, the green light emitting element 52, and the blue light emitting element 53. A series of the red light emitting element 51, the green light emitting element 52, and the blue light emitting element 53 may form a single pixel. In this case, each of the red light emitting element 51, the green light emitting element 52, and the blue light emitting element 53 may form a sub-pixel.

The red light emitting element 51, the green light emitting element 52, and the blue light emitting element 53 may be arranged in a row and spaced apart at a predetermined interval, as shown in FIG. 3. In other embodiments, the red light emitting element 51, the green light emitting element 52, and the blue light emitting element 53 may be arranged in other shapes, such as a triangular shape.

According to an embodiment, the inorganic light emitting element 50 may be coupled to the substrate 40 via the first bump 59a and the second bump 59b.

After transferring the inorganic light emitting element 50 onto the substrate 40 such that the first contact electrode 57a and the second contact electrode 57b of the inorganic light emitting element 50 correspond to the first pad electrode 44a and the second pad electrode 44b of the substrate 40, respectively, heat and pressure may be applied to the inorganic light emitting element 50 to melt the first bump 59a and the second bump 59b. When being molten, the first bump 59a may electrically connect the first contact electrode 57a and the first pad electrode 44a. When being molten, the second bump 59b may electrically connect the second contact electrode 57b and the second pad electrode 44b. Additionally, when being molten, the first bump 59a may bond the first contact electrode 57a and the first pad electrode 44a. When being molten, the second bump 59b may bond the second contact electrode 57b and the second pad electrode 44b.

As described above, the first bump 59a may bond the first contact electrode 57a and the first pad electrode 44a, and the second bump 59b may bond the second contact electrode 57b and the second pad electrode 44b, so that the inorganic light emitting element 50 may be coupled to the substrate 40.

A bonding between the inorganic light emitting element 50 and the substrate 40 by the first bump 59a and the second bump 59b may be relatively weak. According to the disclosure, the display module 30 may include a reflective member 100 formed by underfilling the inorganic light emitting element 50 to strengthen the bonding between the inorganic light emitting element 50 and the substrate 40. The reflective member 100 may reinforce the bonding of the inorganic light emitting element 50 and the substrate 40. In other words, the reflective member 100 may enhance the adhesion of the inorganic light emitting element 50 to the substrate 40.

The reflective member 100 may be formed by underfilling the inorganic light emitting element 50 to cover the side surfaces 55 and the bottom surface 56 of the inorganic light emitting element 50. The reflective member 100 may be formed by dispensing or jetting in a liquid state around the inorganic light emitting element 50. The reflective member 100 may fill a space between the substrate 40 and the bottom surface 56 of the inorganic light emitting element 50 and may be underfilled to cover all four sides of the inorganic light emitting element 50.

The reflective member 100 may be provided to reflect light. According to an embodiment, the reflective member 100 may include a resin 110 and a plurality of reflective beads 120 provided to reflect light. The reflective member 100 may reflect light (incident on the reflective member 100) by including the plurality of reflective beads 120.

The resin 110 may be configured to have a color in the grey range. By having a color in the grey range, which is brighter than the black range, the resin 110 may relatively reduce the absorption rate of light (incident on the resin 110) from the inorganic light emitting element 50.

Expressing the color of the resin 110 in a red/green/blue (RGB) color code, R=G=B, where 0 < R, G, B < 20. The RGB color code may refer to a representation of R, G, and B as integer values ranging from 0 to 255, respectively.

The reflective member 100 may include the plurality of reflective beads 120 that may be distributed within the resin 110. The plurality of reflective beads 120 may be provided to reflect light. The plurality of reflective beads 120 may be provided in a spherical shape with a diameter of, for example, approximately 1 µm to 5 µm.

According to an embodiment, the plurality of reflective beads 120 may include a spherically shaped glass with a diameter of, for example, approximately 1 µm to 5 µm. Alternatively, the plurality of reflective beads 120 may be provided by coating titanium dioxide (TiO₂) aluminum (Al) or silver (Ag) on a spherically shaped glass with a diameter of, for example, approximately 1 µm to 5 µm. Alternatively, the plurality of reflective beads 120 may include spherically shaped titanium dioxide (TiO₂) with a diameter of, for example, approximately 1 µm to 5 µm.

The plurality of reflective beads 120 may cause light incident through the interface to be diffusely reflected from the opposite interface to emit light through the incident interface. The plurality of reflective beads 120 may reflect light incident on the plurality of reflective beads 120. The light incident on the plurality of reflective beads 120 may be reflected and emitted as light parallel to the incident light.

According to an embodiment, the reflective member 100 may be provided or disposed so that a composition ratio of the reflective beads 120 is, for example, 50% or more. For example, the reflective member 100 may be provided or disposed so that the composition ratio of the reflective beads 120 is, for example, 80%. The composition ratio of the reflective beads 120 of the reflective member 100 may refer to the mass occupied by the reflective beads 120 in the total mass of the reflective member 100.

The reflective member 100 may be formed by dispensing a liquid state around the inorganic light emitting element 50, underfilling the inorganic light emitting element 50, and then curing. The reflective member 100 in the liquid state may be dispensed or jetted to fill the space between the bottom surface 56 of the inorganic light emitting element 50 and the substrate 40, and cover the four sides of the inorganic light emitting element 50. The reflective member 100 (dispensed in the liquid state) may be cured by ultraviolet (UV) rays.

The reflective member 100 may have the same height as the inorganic light emitting element 50. In other words, a top surface of the reflective member 100 and the light emitting surface 54a of the inorganic light emitting element 50 may be aligned on the same plane. The reflective member 100 may not cover the light emitting surface 54a of the inorganic light emitting element 50. The reflective member 100 may not protrude in the first direction X further than the light emitting surface 54a of the inorganic light emitting element 50.

The reflective member 100 may be provided to reflect light that is emitted from the inorganic light emitting element 50 and that is incident on the reflective member 100. The reflective member 100 may reflect light emitted through the side surfaces 55 or bottom surface 56 of the inorganic light emitting element 50, thereby improving the light efficiency of the display module 30.

The reflective member 100 may underfill the inorganic light emitting element 50 to cover the side surfaces 55 of the inorganic light emitting element 50. The reflective member 100 may fill an area between the bottom surface 56 of the inorganic light emitting element 50 and the mounting surface 41 of the substrate 40. The reflective member 100 may be dispensed in the liquid state onto the mounting surface 41 of the substrate 40 to fill an area between the mounting surface 41 and the bottom surface 56 of the inorganic light emitting element 50, and then, cover the side surfaces 55 of the inorganic light emitting element 50. The reflective member 100 may be cured by ultraviolet (UV) rays after being dispensed. The reflective member 100 may be dispensed to surround the bottom surface 56 and the side surfaces 55 of the inorganic light emitting element 50 and then cured, thereby enhancing the bonding between the inorganic light emitting element 50 and the substrate 40. According to the disclosure, the inorganic light emitting element 50 may be stably electrically connected and bonded to the substrate 40 by the first bump 59a and the second bump 59b and the reflective member 100.

According to the disclosure, the display module 30 may include a cover member 130 provided to cover the entire mounting surface 41 of the substrate 40 on which the reflective member 100 is not provided and having a black color. The cover member 130 may be provided to cover a side of the reflective member 100 and the entire mounting surface 41 of the substrate 40 outside the reflective member 100.

In an embodiment, as shown in FIG. 3, the cover member 130 may have the same height as the inorganic light emitting element 50 and the reflective member 100. In other words, a top surface of the cover member 130, the top surface of the reflective member 100, and the light emitting surface 54a of the inorganic light emitting element 50 may be aligned on the same plane. The cover member 130 may not cover the top surface of the reflective member 100. The cover member 130 may not protrude in the first direction X further than the light emitting surface 54a of the inorganic light emitting element 50 and the top surface of the reflective member 100.

In an embodiment, the cover member 130 may be provided to have a black color. For example, the cover member 130 may have a black color by including a black colored ink. The cover member 130 may include a resin including a black colored ink, but is not limited thereto. The cover member 130 may have a black color in a variety of ways.

By providing the cover member 130 with a black color, light interference between sub-pixels may be prevented during light emission of the inorganic light emitting element 50. In an embodiment, light emitted from some of the sub-pixels of the red light emitting element 51, the green light emitting element 52, and the blue light emitting element 53 may be reflected from the substrate 40 to prevent interference with light emitted from the remaining sub-pixels. In other words, when the inorganic light emitting element 50 is emitted, the cross-talk phenomenon may be reduced or eliminated, thereby improving the optical characteristics of the display apparatus 1.

The cover member 130 may be formed by dispensing or jetting in a liquid state from the outside of the reflective member 100 and then curing. The cover member 130 may be sprayed onto the mounting surface 41 of the substrate 40 in a liquid state around the reflective member 100. The cover member 130 sprayed onto the substrate 40 in a liquid state may be cured primarily by UV rays, and secondarily, by thermal curing. To thermally cure the cover member 130, heat may be applied to the inorganic light emitting element 50, the reflective member 100, and the cover member 130, or heat and pressure may be applied together.

In the related art, an anisotropic conductive film (ACF) is used to bond an inorganic light emitting element to a substrate. The ACF film is one in which an anisotropic conductive adhesive is attached to a protective film and has a structure in which conductive balls are dispersed in an adhesive resin. A conductive ball is surrounded by a thin insulating film, which may electrically connect conductors to each other by breaking the insulating film under heat and pressure. Some of these conductive balls may be disposed between the pad electrode of the substrate and the contact electrode of the inorganic light emitting element, and may electrically connect the pad electrode of the substrate and the contact electrode of the inorganic light emitting element.

In the case of the ACF described above, the conductive balls may not be patterned and placed, so the conductive balls are present in all areas of the film. This results in more unused conductive balls than those used to electrically connect the substrate and the inorganic light emitting element, which increases material costs. In addition, the conductive balls are unevenly distributed within the ACF, and the conductive balls may not be sufficiently placed between the pad electrode of the substrate and the contact electrode of the inorganic light emitting element. In such cases, the substrate and the inorganic light emitting element may not be electrically connected to each other, i.e., the electrical connection between the inorganic light emitting element and the substrate may be unstable.

In addition, in the related art, after bonding the inorganic light emitting element to the substrate using an anisotropic conductive layer, a black matrix layer is additionally disposed on the substrate. The black matrix layer is configured to cover the entire mounting surface of the substrate, and may include a plurality of holes through which the inorganic light emitting element may penetrate. The black matrix layer may absorb ambient light to make the substrate appear black, thereby improving the contrast of a display.

When the black matrix layer covers the inorganic light emitting element, light emitted from the inorganic light emitting element may be absorbed by the black matrix layer, so that the black matrix layer includes the plurality of holes corresponding to the size and position of the inorganic light emitting element. The size of each of the plurality of holes should be larger than that of the inorganic light emitting element in order for the inorganic light emitting element to pass through the hole. Therefore, there is a limit to reducing the size of the hole provided in the black matrix layer. Ideally, the size of the hole in the black matrix layer should be exactly the same as the size of the inorganic light emitting element, but in practice, the size of the hole should be larger than that of the inorganic light emitting element.

The black matrix layer may be configured to reduce the crosstalk described above. When the size of the holes in the black matrix layer is larger than that of the inorganic light emitting element, an area is formed around the inorganic light emitting element in which the black matrix layer is not provided occurs. Through this area, light interference may occur between the sub-pixels. In other words, crosstalk may occur.

According to an embodiment, the reflective member 100, provided in a gray color, may underfill the inorganic light emitting element 50 to cover the bottom surface 56 and the side surfaces 55 of the inorganic light emitting element 50, and the cover member 130, provided in a black color, may be provided in an outer area of the reflective member 100. The inorganic light emitting element 50 may be metallically bonded to the substrate 40 via the first bump 59a and the second bump 59b. The inorganic light emitting element 50 may be metallically bonded to the substrate 40 via the first bump 59a and the second bump 59b, thereby being stably bonded and electrically connected to the substrate 40.

Light emitted from the inorganic light emitting element 50 may be emitted through the light emitting surface 54a. Light emitted from the bottom surface 56 or the side surfaces 55 of the inorganic light emitting element 50 may be reflected by the reflective member 100 and emitted in the first direction X. The reflective member 100 may reflect light emitted from the bottom surface 56 or the side surfaces 55 of the inorganic light emitting element 50 forward, thereby improving the light efficiency of the inorganic light emitting element 50.

On the outside of the reflective member 100, the cover member 130 having a black color may be provided, which may function as the black matrix layer described above. Unlike the related art, since the cover member 130 of the disclosure is not provided in a form of a film including holes for the inorganic light emitting element 50 and the reflective member 100 to penetrate, as in the ideal black matrix layer described above, the cover member 130 may cover the entire area of mounting surface 41 of the substrate 40 without any areas spaced apart from the reflective member 100. The cover member 130 may cover the entire mounting surface 41 of the substrate 40 except for the area where the inorganic light emitting element 50 and the reflective member 100 are disposed. The cover member 130 may remove or reduce light interference between the sub-pixels 51, 52, and 53, thereby improving the contrast or sharpness of the screen. The cover member 130 may perform a function of supplementing the light absorbing layer 44c formed entirely on the mounting surface 41 side of the substrate 40. The cover member 130 may absorb ambient light to make the substrate 40 appear black, thereby improving the contrast of the screen.

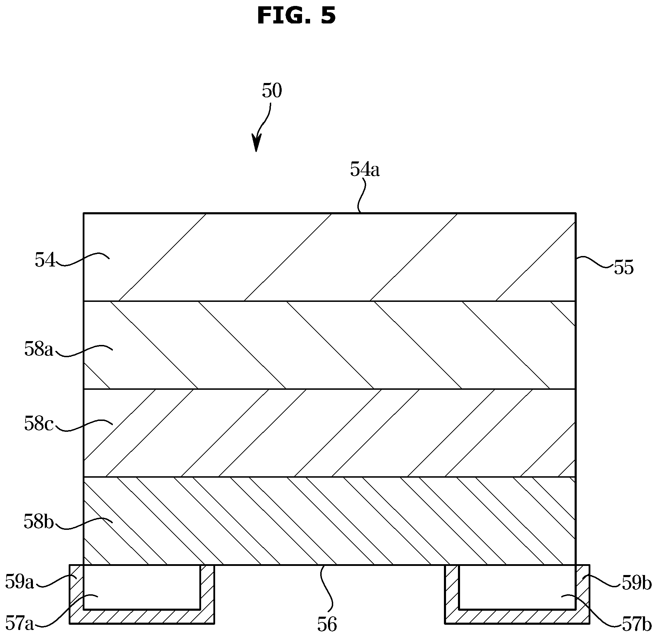

FIG. 5 is a cross-sectional view illustrating the inorganic light emitting element of the display module according to an embodiment of the disclosure.

Referring to FIG. 5, the inorganic light emitting element 50 may include the first bump 59a and the second bump 59b. The first bump 59a and the second bump 59b may include the first bump 59a plated on the first contact electrode 57a and the second bump 59b plated on the second contact electrode 57b.

According to an embodiment, the first bump 59a and the second bump 59b may include indium, tin, or an alloy of indium and tin. For example, the first bump 59a and the second bump 59b may be formed by plating indium on the first contact electrode 57a and the second contact electrode 57b, respectively. For example, the first bump 59a and the second bump 59b may be formed by plating tin on the first contact electrode 57a and the second contact electrode 57b, respectively. For example, the first bump 59a and the second bump 59b may be formed by plating an alloy of indium and tin on the first contact electrode 57a and the second contact electrode 57b, respectively.

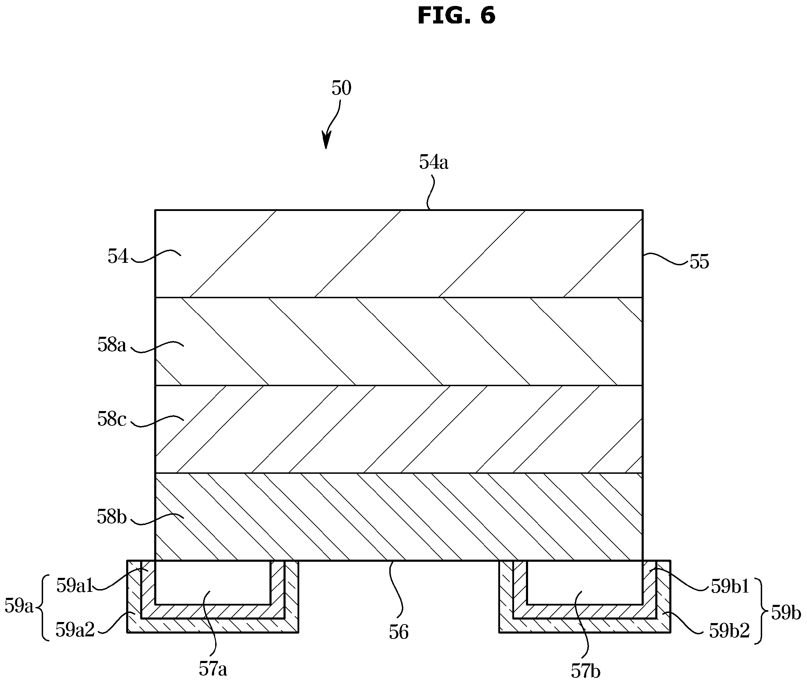

FIG. 6 is a cross-sectional view illustrating the inorganic light emitting element of the display module according to an embodiment of the disclosure.

Referring to FIG. 6, the inorganic light emitting element 50 may include the first bump 59a and the second bump 59b. The first bump 59a and the second bump 59b may include the first bump 59a plated on the first contact electrode 57a and the second bump 59b plated on the second contact electrode 57b.

According to an embodiment, the first bump 59a may include a first layer 59a1 provided to cover the first contact electrode 57a, and a second layer 59a2 provided to cover the first layer 59a1. The second bump 59b may include a first layer 59b1 provided to cover the second contact electrode 57b, and a second layer 59b2 provided to cover the first layer 59b1. In other words, the first bump 59a and the second bump 59b may include two or more multi-layers.

According to an embodiment, the first layer 59a1 (of the first bump 59a) and the first layer 59b1 (of the second bump 59b) may include one of indium and tin, and the second layer 59a2 (of the first bump 59a) and the second layer 59b2 (of the second bump 59b) may include the other one of indium and tin. For example, the first layer 59a1 (of the first bump 59a) and the first layer 59b1 (of the second bump 59b) may include indium, and the second layer 59a2 (of the first bump 59a) and the second layer 59b2 (of the second bump 59b) may include tin. For example, the first layer 59a1 (of the first bump 59a) and the first layer 59b1 (of the second bump 59b) may include tin, and the second layer 59a2 (of the first bump 59a) and the second layer 59b2 (of the second bump 59b) may include indium.

According to an embodiment, the first layer 59a1 (of the first bump 59a) and the first layer 59b1 (of the second bump 59b) may be formed by plating the first contact electrode 57a and the second contact electrode 57b. The second layer 59a2 (of the first bump 59a) and the second layer 59b2 (of the second bump 59b) may be formed by plating the first layer 59a1 (of the first bump 59a) and the first layer 59b1 (of the second bump 59b).

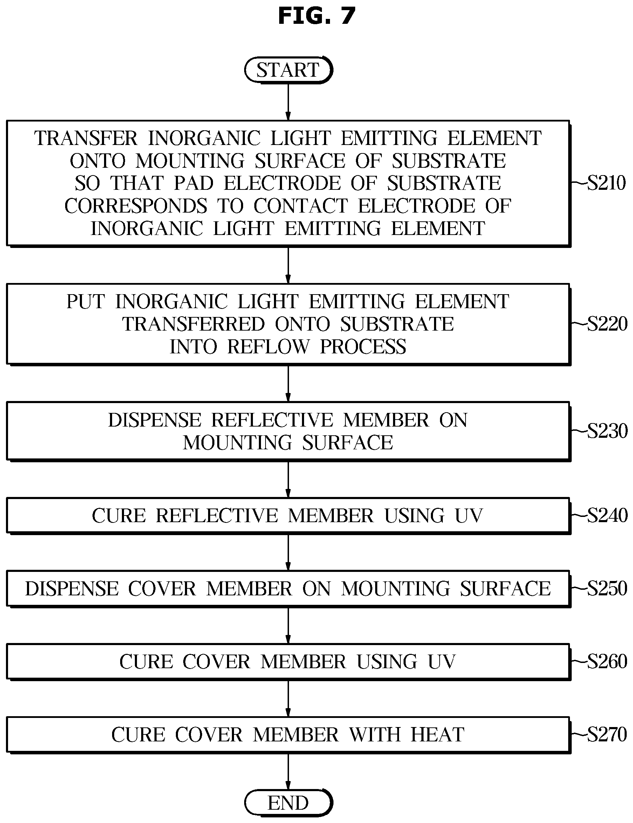

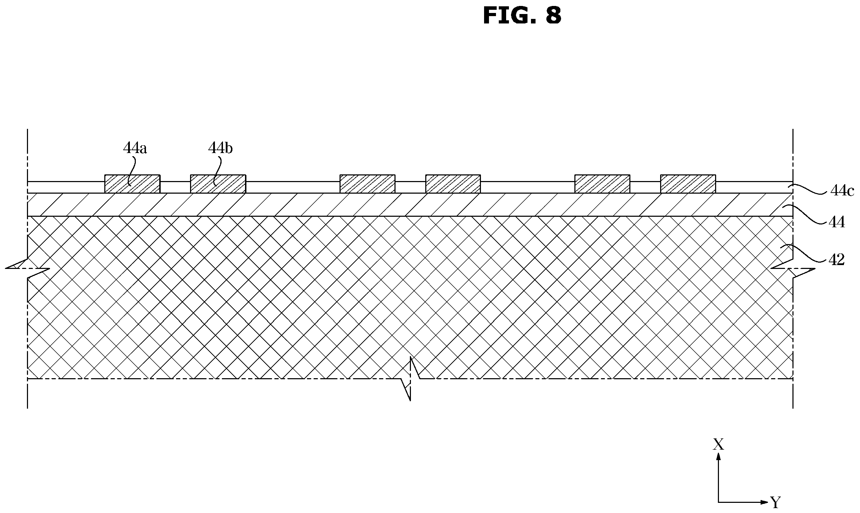

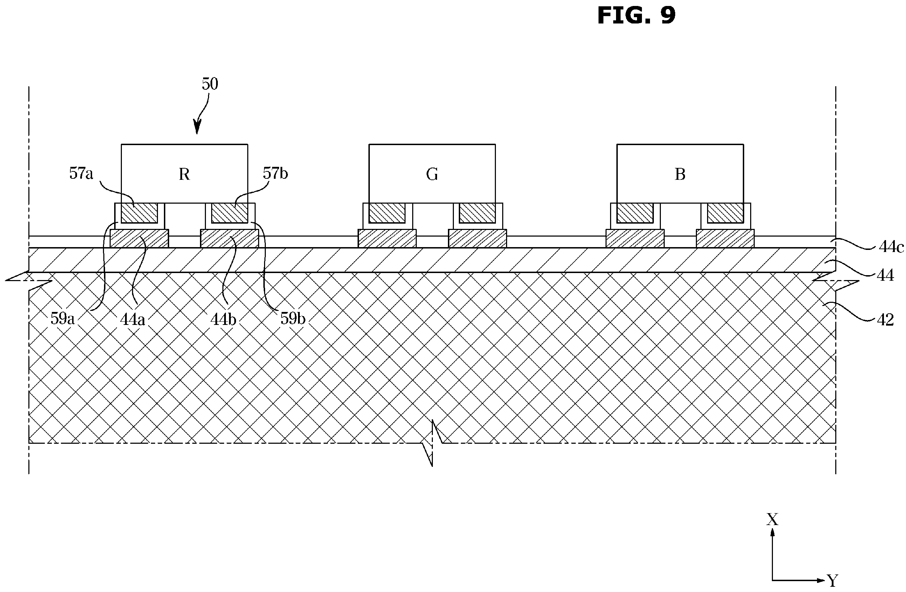

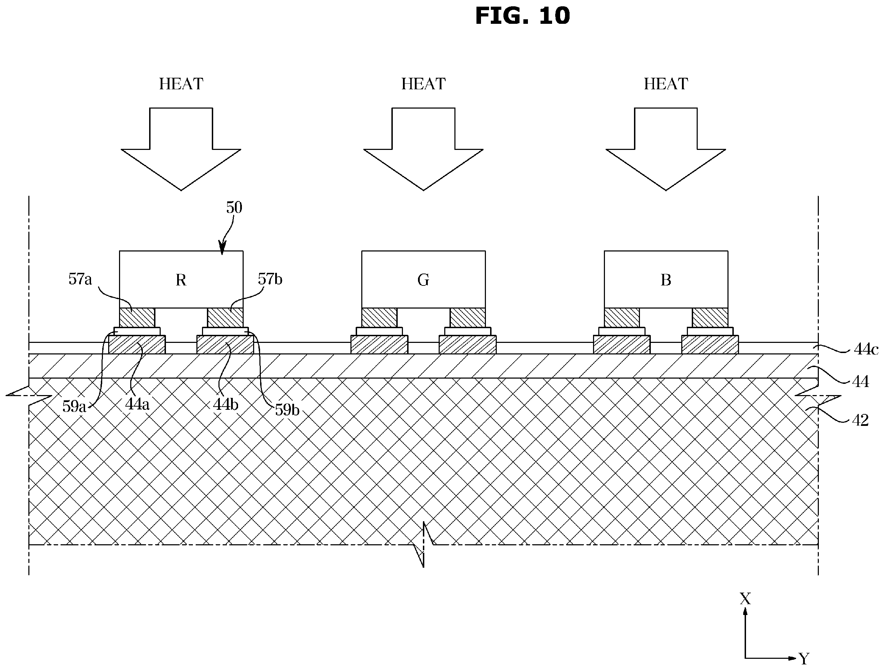

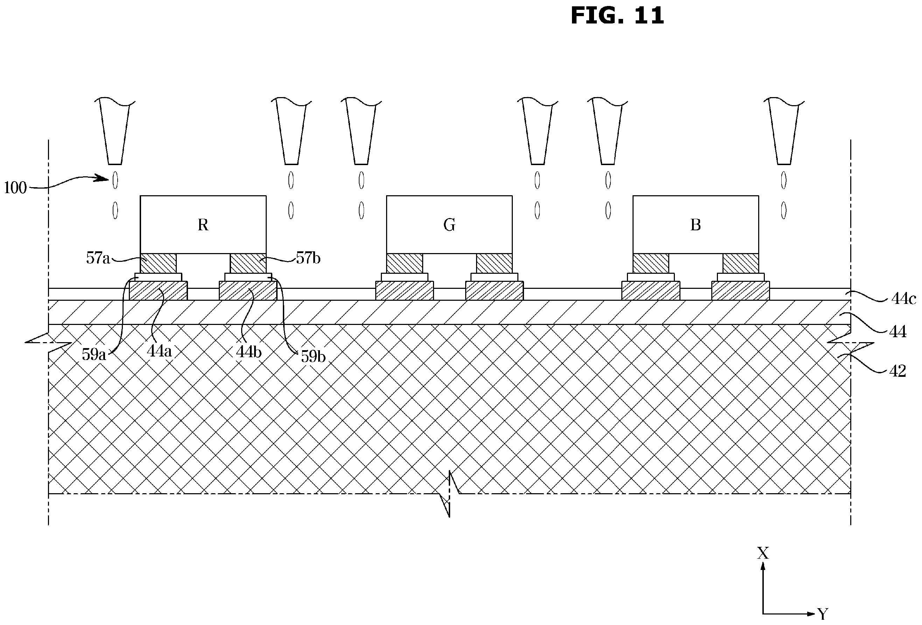

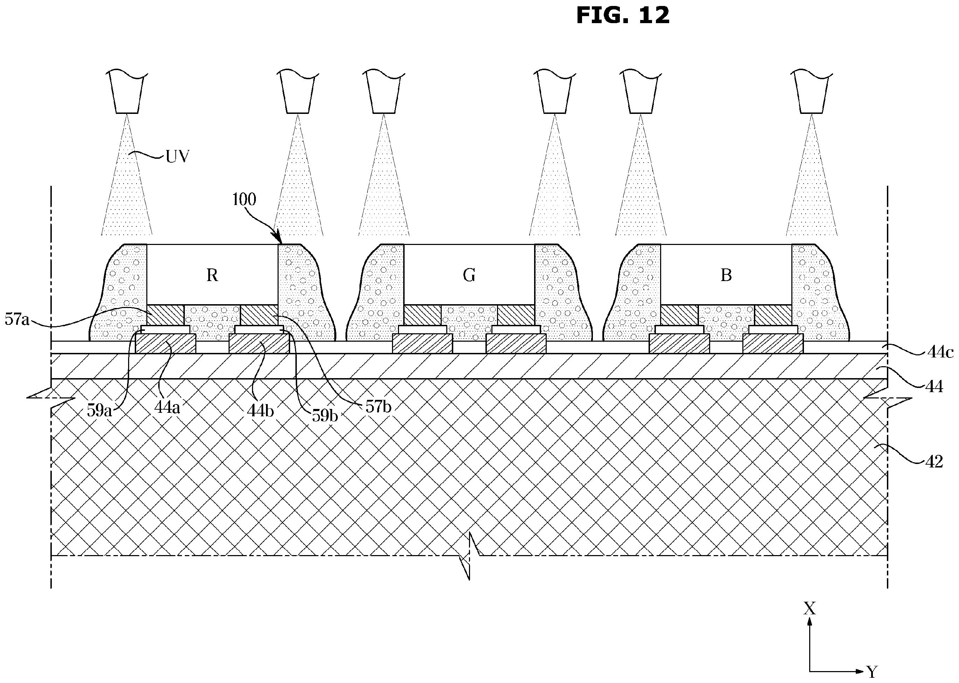

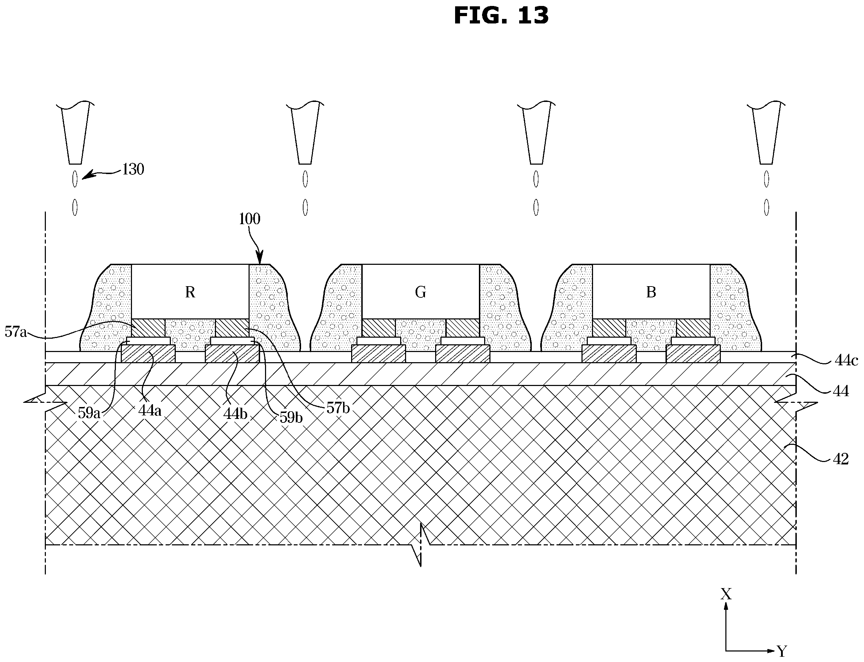

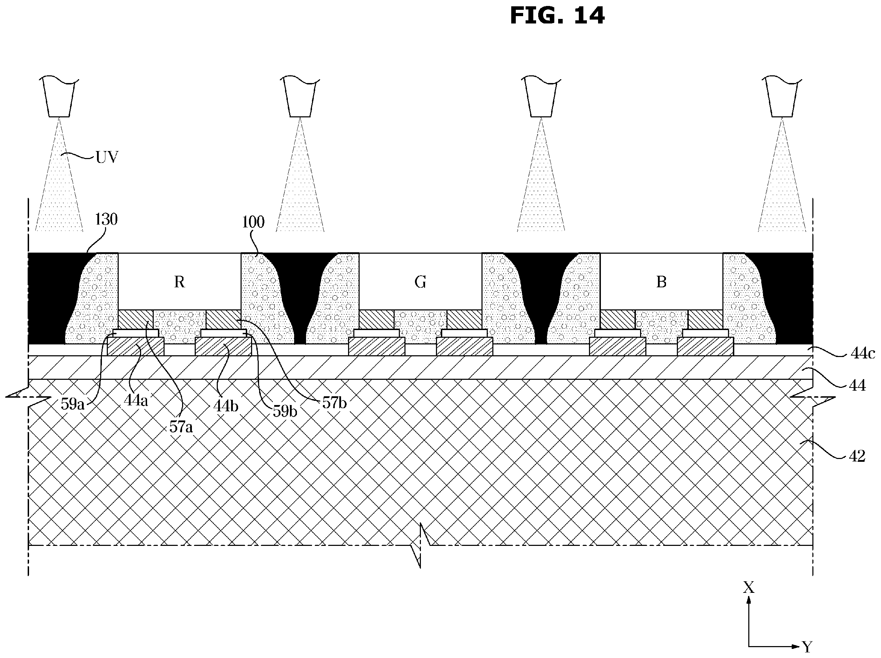

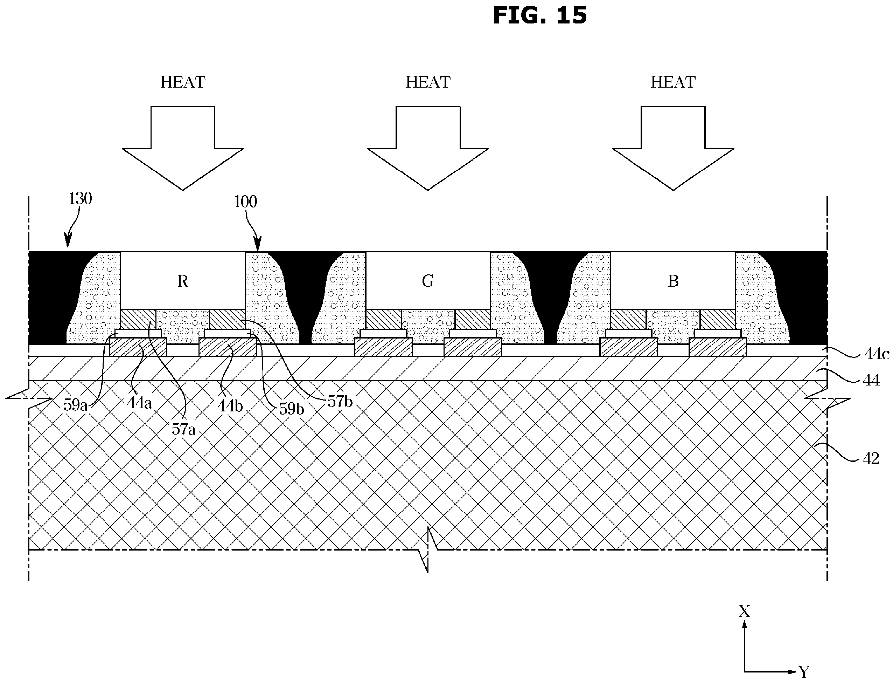

FIG. 7 is a flowchart for a method of manufacturing the display module according to an embodiment of the disclosure. FIG. 8 is a cross-sectional view of the substrate of the display module according to an embodiment of the disclosure. FIG. 9 is a cross-sectional view of the inorganic light emitting element transferred onto the substrate of the display module according to an embodiment of the disclosure. FIG. 10 is a schematic cross-sectional view illustrating the inorganic light-emitting element transferred onto the substrate of the display module according to an embodiment of the disclosure, which is placed in a reflow process. FIG. 11 is a schematic cross-sectional view of dispensing the reflective member 100 onto the substrate of the display module according to an embodiment of the disclosure. FIG. 12 is a schematic cross-sectional view of UV curing of the reflective member 100 dispensed onto the substrate of the display module according to an embodiment of the disclosure. FIG. 13 is a schematic cross-sectional view of dispensing the cover member onto the substrate of the display module according to an embodiment of the disclosure. FIG. 14 is a schematic cross-sectional view of UV curing of the cover member dispensed onto the substrate of the display module according to an embodiment of the disclosure. FIG. 15 is a schematic cross-sectional view of heat curing of the cover member of the display module according to an embodiment of the disclosure.

Hereinafter, a method of manufacturing the display module according to an embodiment will be described with reference to FIGS. 7 to 15.

Referring to FIG. 7, the method of manufacturing the display module according to an embodiment may include transferring the inorganic light emitting element onto the mounting surface of the substrate such that the pad electrode of the substrate corresponds to the contact electrode of the inorganic light emitting element (S210), putting the inorganic light emitting element into a reflow process such that the bump provided between the pad electrode and the contact electrode is melted (S220), dispensing the reflective member 100 in a liquid state on the mounting surface (S230), curing the reflective member 100 (S240), dispensing the cover member in a liquid state on the mounting surface (S250), and curing the cover member using UV (S260) and with heat (S270).

Referring to FIG. 8, the pad electrodes 44a and 44b may be formed on the TFT layer 44 of the substrate 40.

Referring to FIG. 9, the light emitting element 50 may be transferred on the mounting surface 41 of the substrate 40 such that the pad electrodes 44a and 44b (of the substrate 40) and the contact electrodes 57a and 57b (of the inorganic light emitting element 50) correspond to each other.

The inorganic light emitting element 50 may be picked up from a sapphire or silicon wafer and transferred directly onto the substrate 40. The plurality of inorganic light emitting elements 50 may be picked up and transferred by means of an electrostatic method using an electrostatic head or a stamp method using an elastic polymer material, such as PDMS or silicon as a head. The plurality of inorganic light emitting elements 50 may be transferred onto the substrate 40 in various ways other than those described above.

Referring to FIG. 10, the first bump 59a and the second bump 59b arranged between the contact electrodes 57a and 57b and the pad electrodes 44a and 44b may be melted by applying heat to the plurality of inorganic light emitting elements 50 transferred onto the substrate 40. In other words, the first bump 59a and the second bump 59b may be melted by inputting the plurality of inorganic light emitting elements 50 into the reflow process.

When being molten, the first bump 59a and the second bump 59b may electrically connect the contact electrodes 57a and 57b of the inorganic light emitting element 50 and the pad electrodes 44a and 44b of the substrate 40. When being molten, the first bump 59a and the second bump 59b may metallically bond the contact electrodes 57a and 57b of the inorganic light emitting element 50 and the pad electrodes 44a and 44b of the substrate 40. When being molten, the first bump 59a and the second bump 59b may stably electrically connect the contact electrodes 57a and 57b (of the inorganic light emitting element 50) to the pad electrodes 44a and 44b (of the substrate 40).

Referring to FIG. 11, after the reflow process, the reflective member 100 may be dispensed in the liquid state on the substrate 40.

The reflective member 100 may be dispensed in the liquid state around the inorganic light emitting element 50 to underfill the inorganic light emitting element 50. In other words, the reflective member 100 may be dispensed onto the substrate 40 such that the reflective member 100 in the liquid state fills the space between the substrate 40 and the bottom surface of the inorganic light emitting element 50. The reflective member 100 in the liquid state may be dispensed onto the substrate 40 such that the reflective member 100 covers the side surfaces 55 of the inorganic light emitting element 50.

Referring to FIG. 12, UV may be used to cure the reflective member 100 dispensed onto the substrate 40 in the liquid state. The reflective member 100 may be cured by exposure to UV. According to an embodiment, the reflective member 100 may be primarily cured by UV, as may the cover member 130, which will be described later.

Referring to FIG. 13, the cover member 130 may be dispensed in the liquid state around the reflective member 100. The cover member 130 may be dispensed to cover the entire area of the substrate 40 where the inorganic light emitting element 50 and the reflective member 100 are not provided. The cover member 130 may be dispensed to cover the entire area outside the reflective member 100 on the substrate 40.

Referring to FIG. 14, the cover member 130 dispensed onto the substrate 40 in the liquid state may be first cured by applying UV. The cover member 130 exposed to UV may be primarily cured.

Referring to FIG. 15, the cover member 130 that has been primarily cured by UV may be secondarily cured by applying heat.

According to an embodiment, the cover member 130 may have a predetermined hardness by applying heat to the cover member 130 that has been primarily cured by UV. The predetermined hardness may refer to a hardness greater than that of the cover member 130 cured by UV.

According to an embodiment, the cover member 130 may be secondarily cured by heat and pressure. In this case, heat and pressure may be applied to the cover member 130 together to harden the cover member 130.

The secondarily cured cover member 130 may support the reflective member 100 so that the reflective member 100 is secured in a predetermined position on the substrate 40. In other words, the cover member 130 may fix the position of the reflective member 100 by contacting the side surfaces of the reflective member 100.

The display module 30 according to an embodiment of the disclosure may include the substrate 40 including the mounting surface 41 and the pad electrodes 44a and 44b provided on the mounting surface 41, the inorganic light emitting element 50 including the contact electrodes 57a and 57b provided to correspond to the contact electrode, the first bump 59a and the second bump 59b disposed between the pad electrode and the contact electrode to bond the pad electrode and the contact electrode and electrically connect the pad electrode and the contact electrode, the reflective member 100 configured to underfill the inorganic light emitting element to cover the side surfaces 55 and the bottom surface56 of the inorganic light emitting element and reflect light, and the cover member 130 configured to cover the side surfaces of the reflective member 100 and the mounting surface and having a black color.

The reflective member 100 may be formed by dispensing the resin 110 having a color in the grey range onto the substrate.

The reflective member 100 may include the plurality of reflective beads 120 distributed within the resin and configured to reflect light.

Each of the plurality of reflective beads may be provided in a spherical shape with a diameter of 1 µm to 5 µm.

The plurality of reflective beads may include at least one of titanium dioxide (TiO₂), glass, aluminum (Al), and silver (Ag).

The cover member may be configured to cover the entire area outside the reflective member 100 on the mounting surface.

The cover member may be formed by dispensing the resin configured to include an ink in the black range onto the substrate.

The top surface of the inorganic light emitting element may face the first direction, and the top surface of the reflective member 100 may be provided so as not to protrude further in the first direction than the top surface of the inorganic light emitting element.

The top surface of the inorganic light emitting element may face the first direction, and the top surface of the cover member may be provided so as not to protrude further in the first direction than the top surface of the inorganic light emitting element.

The top surface of the inorganic light emitting element, the top surface of the reflective member 100, and the top surface of the cover member may be aligned in the same plane.

The bump may be plated on the contact electrode to cover the contact electrode.

The bump may electrically connect the contact electrode and the pad electrode by melting.

The bump may be configured to include indium, tin, or an alloy of indium and tin.

The bump may include the first layer 59a1 (of the first bump 59a) and the first layer 59b1 (of the second bump 59b) configured to cover the contact electrode and including one of indium and tin, and the second layer 59a2 (of the first bump 59a) and the second layer 59b2 (of the second bump 59b) configured to cover the first layer and including the other one of indium and tin.

The reflective member 100 may underfill the inorganic light emitting element to enhance the bonding between the inorganic light emitting element and the substrate.

A method of manufacturing a display module according to an embodiment of the disclosure may include transferring the inorganic light emitting element onto the mounting surface of the substrate so that the pad electrode of the substrate corresponds to the contact electrode of the inorganic light emitting element (S210), putting the inorganic light emitting element into the reflow process so that the bump provided between the pad electrode and the contact electrode is melted (S220), dispensing the reflective member 100 in the liquid state on the mounting surface (S230), curing the reflective member 100 (S240), dispensing the cover member in the liquid state on the mounting surface (S250), and curing the cover member using UV (S260) and with heat (S270).

The reflective member 100 may be cured by UV rays.

The cover member may be primarily cured by UV and secondarily cured by heat.

The reflective member 100 may be configured to underfill the inorganic light emitting element to cover the side surfaces and a bottom surface of the inorganic light emitting element and reflect light.

The cover member may be configured to cover the side surfaces of the reflective member 100 and the mounting surface, and may be configured to have a black color.

The reflective member 100 may include the resin configured to have a color in the grey range, and the plurality of reflective beads distributed within the resin and configured to reflect light.

According to embodiments of the disclosure, the display module in which the electrical connection between the electrode of the inorganic light emitting element and the electrode of the substrate is stabilized may be provided, and the method of manufacturing the same.

According to embodiments of the disclosure, the display module with enhanced bonding between the inorganic light emitting element and the substrate may be provided, and the method of manufacturing the same.

According to embodiments of the disclosure, the display module including the inorganic light emitting element with improved light efficiency may be provided, and the method of manufacturing the same.

According to embodiments of the disclosure, the display module with reduced material costs may be provided, and the method of manufacturing the same.

While the disclosure has been particularly described with reference to exemplary embodiments, it should be understood by those of skilled in the art that various changes in form and details may be made without departing from the scope of the disclosure.

## Claims

1. A display module comprising:
a substrate including a mounting surface and a pad electrode on the mounting surface;
an inorganic light emitting element including a contact electrode corresponding to the pad electrode;
a bump disposed between the pad electrode and the contact electrode to bond the pad electrode and the contact electrode, the bump being electrically connecting the pad electrode to the contact electrode;
a reflective member configured to underfill the inorganic light emitting element to cover side surfaces of the inorganic light emitting element and a bottom surface of the inorganic light emitting element, and configured to reflect light; and
a cover member configured to cover side surfaces of the reflective member and the mounting surface of the substrate, the cover member having a black color.

2. The display module of claim 1, wherein the reflective member is formed by dispensing a resin onto the substrate, and
wherein the resin is configured to have a color in a grey range.

3. The display module of claim 2, wherein the reflective member includes a plurality of reflective beads distributed within the resin.

4. The display module of claim 3, wherein each of the plurality of reflective beads is in a spherical shape with a diameter of about 1 µm to about 5 µm.

5. The display module of claim 3, wherein the plurality of reflective beads are configured to include at least one of titanium dioxide (TiO₂), glass, aluminum (Al), or silver (Ag).

6. The display module of claim 1, wherein the cover member is configured to cover an entire area outside the reflective member on the mounting surface of the substrate.

7. The display module of claim 1, wherein the cover member is formed by dispensing a resin onto the substrate, and
wherein the resin is configured to include an ink in a black range.

8. The display module of claim 1, wherein a top surface of the inorganic light emitting element faces a first direction, and
wherein a top surface of the reflective member does not protrude in the first direction than the top surface of the inorganic light emitting element.

9. The display module of claim 1, wherein a top surface of the inorganic light emitting element faces a first direction, and
wherein a top surface of the cover member does not protrude further in the first direction than the top surface of the inorganic light emitting element.

10. The display module of claim 1, wherein a top surface of the inorganic light emitting element, a top surface of the reflective member, and a top surface of the cover member are aligned in a same plane.

11. The display module of claim 1, wherein the bump is plated on the contact electrode to cover the contact electrode, and
wherein the bump electrically connects the contact electrode and the pad electrode by melting.

12. The display module of claim 1, wherein the bump is configured to include at least one of indium, tin, or an alloy of indium.

13. The display module of claim 1, wherein the bump comprises:
a first layer configured to cover the contact electrode, the first layer including at least one of indium or tin, and
a second layer configured to cover the first layer, the second layer including at least one of indium or tin, which is not included in the first layer.

14. The display module of claim 1, wherein the reflective member is configured to underfill the inorganic light emitting element to enhance a bonding between the inorganic light emitting element and the substrate.
